# EUROPEAN PATENT SPECIFICATION

(11) **EP 4 387 101 B1**
(45) Date of publication and mention of the grant of the patent: **30.09.2026**
(21) Application number: 23211231.8
(22) Date of filing: 21.11.2023
(51) Int. Cl.: H03K 17/082, G01R 19/165, H10D 62/85

(54) **A GAN DIE HAVING A MAIN GAN POWER TRANSISTOR AND A GAN CURRENT SENSE TRANSISTOR**
GAN-CHIP MIT EINEM HAUPT-GAN-LEISTUNGSTRANSISTOR UND EINEM GAN-STROMMESSTRANSISTOR
PUCE GAN AYANT UN TRANSISTOR DE PUISSANCE GAN PRINCIPAL ET UN TRANSISTOR DE DÉTECTION DE COURANT GAN

(30) Priority: 14.12.2022 US 202218081053
(43) Date of publication of application: 19.06.2024
(73) Proprietor: Infineon Technologies Austria AG, 9500 Villach (AT)
(72) Inventor: BERNARDON, Derek, 9524 Villach (AT); FERIANZ, Thomas, 9551 Bodensdorf (AT)
(74) Representative: Stöckeler, Ferdinand

(56) References cited:
- US-A1- 2005 218 963
- US-A1- 2013 001 792
- US-A1- 2019 140 630
- US-B2- 9 791 881
- ALEX LIDOW, MICHAEL DE ROOIJ,: "eGaN® FET Electrical Characteristics", 1 January 2012 (2012-01-01), Retrieved from the Internet <URL:https://epc-co.com/epc/Portals/0/epc/documents/papers/eGaN%20FET%20Electrical%20Characteristics.pdf> [retrieved on 20260409]
- SELVARAJRAVI: "Reverse conduction in the GaN HEMT device", 27 June 2025 (2025-06-27), Retrieved from the Internet <URL:https://community.infineon.com/t5/Knowledge-Base-Articles/Reverse-conduction-in-the-GaN-HEMT-device/ta-p/1045445> [retrieved on 20260409]

## Description

### BACKGROUND

GaN (gallium nitride) technology enables higher switching frequencies, e.g., above 200 to 250kHz. Many power electronics applications approach such high frequencies with low operational duty cycles, making it significantly more difficult to have accurate current sensing that is fast enough to track the current through a GaN power device that is in the ON phase for very short times. Another problem is the aging of the main GaN power device with respect to the sense device which results in decreasing current sense accuracy over time. A further problem is sensing voltages that can go up to 600V or higher with a low voltage technology such as Si (silicon). Providing low voltage protection on a GaN die involves several trade-offs and therefore is challenging to achieve.

Thus, there is a need for improved current sensing technology of GaN dies.

US 2013/001792 A1 discloses a power MOSFET for switching and a sense MOSFET having an area smaller than that of the power MOSFET and configured to detect an electric current flowing through the power MOSFET, which are formed within one semiconductor chip and the semiconductor chip is mounted over a chip mounting part via an electrically conductive joining material and sealed with a resin.

US 2019/140630 A1 discloses a GaN transistor switch having an integrated drain voltage sense circuit.

US 9 791 881 B2 discloses a power converter with an isolated topology, which includes a power transistor, a sense transistor, and a read-out circuit.

### SUMMARY

The invention provides a GaN (gallium nitride) die according to claim 1 and a power electronics device according to claim 5. Further developments of the invention are defined in the dependent claims.

Those skilled in the art will recognize additional features and advantages upon reading the following detailed description, and upon viewing the accompanying drawings.

### BRIEF DESCRIPTION OF THE FIGURES

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
FIG. 1 illustrates a schematic diagram of an embodiment of a GaN die with high voltage protection for external current sense circuitry electrically connected to the current sense terminals of the GaN die.
FIG. 2 illustrates a schematic diagram of another embodiment of the GaN die and the external current sense circuitry.
FIG. 3 illustrates a schematic diagram of another embodiment of the external current sense circuitry.
FIG. 4 illustrates a schematic diagram of another embodiment of the external current sense circuitry.
FIG. 5 illustrates a schematic diagram of another embodiment of the external current sense circuitry.
FIG. 6 illustrates a schematic diagram of another embodiment of the external current sense circuitry.
FIG. 7 illustrates a schematic diagram of another embodiment of the external current sense circuitry.
FIG. 8 illustrates a schematic diagram of another embodiment of the GaN die and the external current sense circuitry.

### DETAILED DESCRIPTION

Described herein are embodiments of a die (chip) such as a GaN die having current sense readout circuitry with low voltage protection, for enabling current sensing, e.g., with a low voltage technology such as Si (silicon). Also described herein are embodiments of current sense circuitry that can be used with the dies described herein or with other power semiconductor dies that provide current sense readouts.

Described next, with reference to the figures, are exemplary embodiments of the die and current sense circuitry.

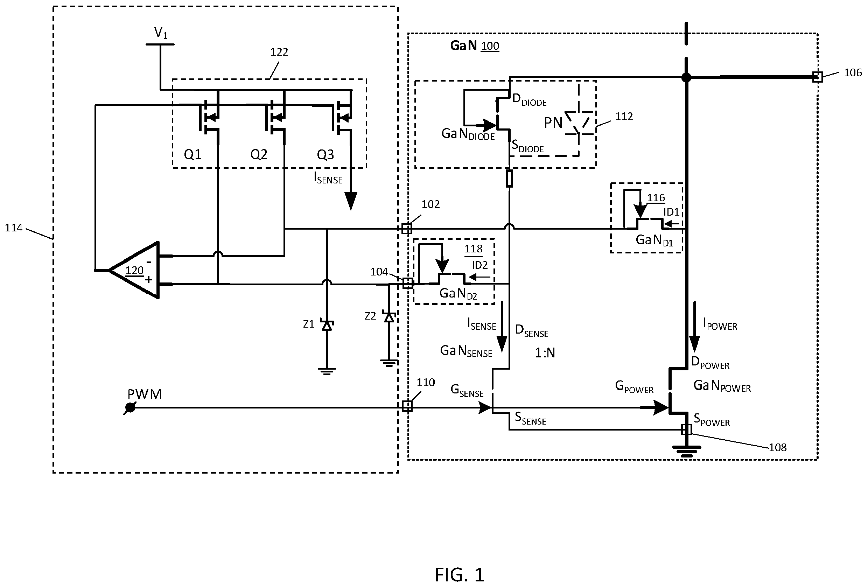

FIG. 1 illustrates an embodiment of a die 100. The die 100 is described herein as a GaN die that includes GaN devices, but the die 100 may utilize another semiconductor technology such as Si, SiC, etc. Accordingly, the function of the devices included in the die 100 are technology independent but described herein in the context of GaN technology. As such, the transistors, diode devices, etc. described herein and that are included in the die 100 may be GaN devices, Si devices, SiC devices, etc.

With this understanding, the GaN die 100 includes a first current sense terminal 102, a second current sense terminal 104, a main GaN power transistor GaN_{POWER}, and a GaN current sense transistor GaN_{SENSE}. The GaN die 100 includes additional terminals such as a drain terminal 106, a source terminal 108 and a control terminal 110. The terminals 102, 104, 106, 108, 110 may be bond or contact pads at the frontside and/or backside of the GaN die 100, for example. The on/off state of the GaN current sense transistor GaN_{SENSE} and the main GaN power transistor GaN_{POWER} is controlled by a signal such as a PWM (pulse width modulation) signal that drives the gate terminal 110 of the GaN die 100.

The main GaN power transistor GaN_{POWER} included in the GaN die 100 may be part of a low-side switch device of any type of power electronics device that operates at a relatively high frequency, e.g., above 200 to 250kHz and which requires accurate current sensing. For example, the main GaN power transistor GaN_{POWER} may be part of a low-side switch for a power, boost converter, Flyback converter, PFC (power factor correction) stage, etc.

The source S_{SENSE} of the GaN current sense transistor GaN_{SENSE} is electrically connected to the source S_{POWER} of the main GaN power transistor GaN_{POWER}. The GaN current sense transistor GaN_{SENSE} provides a scaled-down replica I_{SENSE} of the current I_{POWER} flowing in the main GaN power transistor GaN_{POWER}. In one embodiment, the channel width of the GaN current sense transistor GaN_{SENSE} is in a range of 1:2000 to 1:4000 of the channel width of the main GaN power transistor GaN_{POWER}.

The main GaN power transistor GaN_{POWER} and the GaN current sense transistor GaN_{SENSE} may be normally-off (i.e., enhancement mode) devices, for example. For a normally-off device, a current conduction channel is not present between the drain and source D_{POWER}, S_{POWER} / D_{SENSE}, S_{SENSE} of the corresponding GaN transistor GaN_{POWER} / GaN_{SENSE} without a suitable voltage applied to the gate G_{POWER} / G_{SENSE} of the GaN transistor GaN_{POWER} / GaN_{SENSE}. In one embodiment, the main GaN power transistor GaN_{POWER} and the GaN current sense transistor GaN_{SENSE} are gate injection transistors (GITs) which are hybrid-drain HEMTs (high electron mobility transistors) with a p-GaN gate that results in a normally-off power switch.

The GaN die 100 also includes a diode device 112 electrically connected in series between the drain D_{POWER} of the main GaN power transistor GaN_{POWER} and the drain D_{SENSE} of the GaN current sense transistor GaN_{SENSE}. In one embodiment, the diode device 112 is a GaN transistor GaN_{DIODE} having a drain D_{DIODE} electrically connected to the drain D_{POWER} of the main GaN power transistor GaN_{POWER}, a source S_{DIODE} electrically connected to the drain D_{SENSE} of the GaN current sense transistor GaN_{SENSE}, and a gate electrically connected to the drain of the GaN transistor. In another embodiment, the diode device 112 is a pn diode PN having an anode electrically connected to the drain D_{POWER} of the main GaN power transistor GaN_{POWER} and a cathode electrically connected to the drain D_{SENSE} of the GaN current sense transistor GaN_{SENSE}. The pn diode PN is illustrated with dashed lines in FIG. 1 to indicate that the either the GaN transistor GaN_{DIODE} configured as a HEMT-gated diode or the pn diode PN may be electrically connected in series between the drain D_{POWER} of the main GaN power transistor GaN_{POWER} and the drain D_{SENSE} of the GaN current sense transistor GaN_{SENSE}.

In either case, the diode device 112 is subjected to the same drain voltage as the main GaN power transistor GaN_{POWER} which should cause the GaN current sense transistor GaN_{SENSE} to age at the same rate as the main GaN power transistor GaN_{POWER}. However, this now causes a high voltage, e.g., go up to 600V or higher on the drain D_{SENSE} of the GaN current sense transistor GaN_{SENSE} which needs to be protected in case external current sense circuitry 114 electrically connected to the first and second current sense terminals 102, 104 of the GaN die 100 is implemented using a low voltage technology such as Si (silicon).

The GaN die 100 provides low voltage protection for the external current sense circuitry 114 via a first voltage protection device 116 and a second voltage protection device 118. The first voltage protection device 116 electrically connects the drain D_{POWER} of the main GaN power transistor GaN_{POWER} to the first sense terminal 102 and protects the current sense circuitry 114 from the full drain voltage, e.g., go up to 600V or higher of the main GaN power transistor GaN_{POWER}. The second voltage protection device 118 electrically connects the drain D_{SENSE} of the GaN current sense transistor GaN_{SENSE} to the second sense terminal 104 and protects the current sense circuitry 114 from the full drain voltage of the GaN current sense transistor GaN_{SENSE}. In one embodiment, each of the main GaN power transistor GaN_{POWER}, the GaN current sense transistor GaN_{SENSE}, the first voltage protection device 116, and the second voltage protection device 118 is a Schottky-gate HEMT device where a p-GaN layer can be either partially depleted by a metal/p-GaN Schottky junction or fully depleted, depending on the doping concentration and thickness of the p-GaN layer.

In FIG. 1, the current sense circuitry 114 includes a comparator 120, a current source circuit 122, a first Zener diode Z1 that clamps the voltage at the first current sense terminal 102 of the GaN die 100, and a second Zener diode Z2 that clamps the voltage at the second current sense terminal 104 of the GaN die 100. The comparator 120 has a negative input electrically connected to the first current sense terminal 102 and a positive input electrically connected to the second current sense terminal 104. The current source circuit 122 is controlled by the output of the comparator 120 and forces a current ID1 through the first voltage protection device 116 of the GaN die 100 and that minimizes the voltage difference across the first and second sense terminals 102, 104 of the GaN die 100.

In FIG. 1, the current source circuit 122 includes a first pMOS transistor Q1, a second pMOS transistor Q2, and a third pMOS transistor Q3 each controlled by the output of the comparator 120 and having a source electrically connected to the voltage source V₁. The drain of the first pMOS transistor Q1 is electrically connected to the second current sense terminal 104. The drain of the second pMOS transistor Q2 is electrically connected to the first current sense terminal 102. The drain of the third pMOS transistor Q3 forms a current sense output I_{SENSE} of the current sense circuitry 114.

In FIG. 1, the first voltage protection device 116 of the GaN die 100 is a first diode device implemented as a first GaN transistor GaN_{D1} that has a drain electrically connected to the drain D_{POWER} of the main GaN power transistor GaN_{POWER}, a source electrically connected to the first sense terminal 102, and a gate electrically connected to the source of the first GaN transistor GaN_{D1}. Likewise, the second voltage protection device 118 of the GaN die 100 is a second diode device that may be implemented as a second GaN transistor GaN_{D2} that has a drain electrically connected to the drain D_{SENSE} of the GaN current sense transistor GaN_{SENSE}, a source electrically connected to the second sense terminal 104, and a gate electrically connected to the source of the second GaN transistor GaN_{D2}. The current source circuit 122 of the external current sense circuitry 114 sets the first current ID1 that flows through the first diode device GaN_{D1} and the second current ID2 that flows through the second diode device GaN_{D2}, based on the comparator output. If the first current ID1 is set equal to the second current ID2, then the voltage drop is the same. Current consumption may be reduced by lowering the first current ID1 and the size of first diode device GaN_{D1} such that the voltage drop remains the same. Another option is to use a fixed current source for ID1, which implies less accurate sensing.

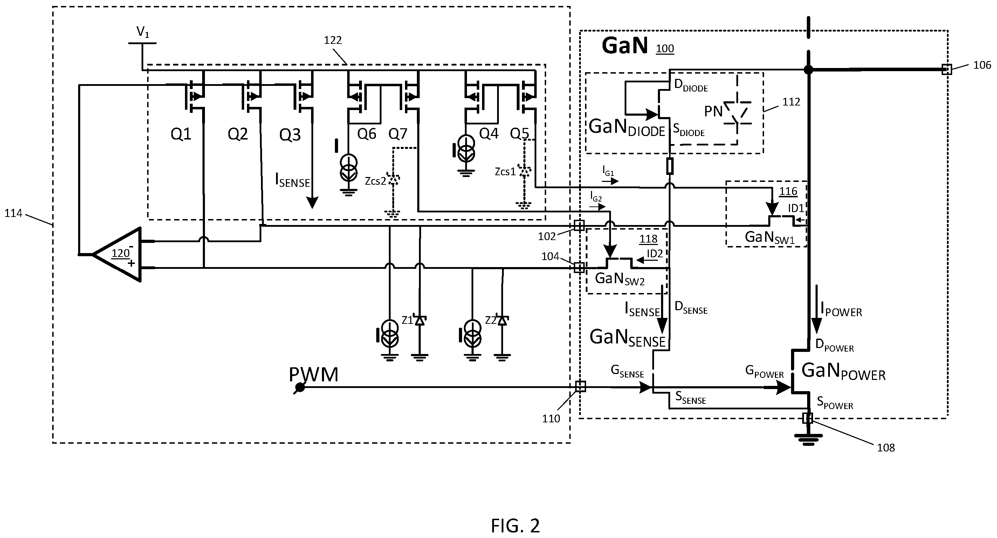

FIG. 2 illustrates another embodiment of the GaN die 100 and the external current sense circuitry 114. According to this embodiment, the first voltage protection device 116 of the GaN die 100 is implemented as a first GaN transistor GaN_{SW1} that is used exclusively as a switch device and configured to be on when the main GaN power transistor GaN_{POWER} is on and to be off when the main GaN power transistor GaN_{POWER} is off. The second voltage protection device 118 is implemented as a second GaN transistor GaN_{SW2} used exclusively as a switch device and configured to be on when the GaN current sense transistor GaN_{SENSE} is on and to be off when the GaN current sense transistor GaN_{SENSE} is off.

The drain of the first GaN switch device GaN_{SW1} is electrically connected to the drain D_{POWER} of the main GaN power transistor GaN_{POWER} and the source of the first GaN switch device GaN_{SW1} is electrically connected to the first current sense terminal 102 of the GaN die 100. The drain of the second GaN switch device GaN_{SW2} is electrically connected to the drain D_{SENSE} of the GaN current sense transistor GaN_{SENSE} and the source of the second GaN switch device GaN_{SW2} is electrically connected to the second current sense terminal 104 of the Gan die 100. The gate and source of the first GaN switch device GaN_{SW1} float with the drain of the main GaN power transistor GaN_{POWER} up to the clamping voltage of the first Zener diode Z1. The gate and source of the second GaN switch device GaN_{SW2} float with the drain of the GaN current sense transistor GaN_{SENSE} up to the clamping voltage of the second Zener diode Z2. The current source circuit 122 of the external current sense circuitry 114 sets a first current ID1 that flows through the first GaN switch device GaN_{SW1} and a second current ID2 that flows through the second GaN switch device GaN_{SW2}, based on the comparator output.

In FIG. 2, the current source circuit 122 of the external current sense circuitry 114 includes a first pMOS transistor Q1 controlled by the output of the comparator 120 having a source electrically connected to the voltage source V₁ and a drain electrically connected to the first current sense terminal 102, a second pMOS transistor Q2 controlled by the output of the comparator 120 and having a source electrically connected to the voltage source V₁ and a drain electrically connected to the second current sense terminal 104, and an additional pMOS transistor Q3 controlled by the output of the comparator 120 and having a source electrically connected to the voltage source V₁ and a drain that forms the current sense output I_{SENSE} of the current sense circuitry 114.

In FIG. 2, the current source circuit 122 also includes a first current source formed by a first pair of pMOS transistors Q4, Q5 and a constant current source 'I'. The first current source injects a first gate current I_{G1} into the gate of the first GaN switch device GaN_{SW1} that forms the first voltage protection device 116 of the GaN die 100. The first current source may also include a Zener diode Zcs1 that clamps the voltage at the gate of the first GaN switch device GaN_{SW1}.

The current source circuit 122 further includes a second current source formed by a second pair of pMOS transistors Q6, Q7 and a constant current source 'I'. The second current source injects a second gate current I_{G2} into the gate of the second GaN switch device GaN_{SW2} that forms the second voltage protection device 118 of the GaN die 100 in FIG. 2. The second current source may also include a Zener diode Zcs2 that clamps the voltage at the gate of the second GaN switch device GaN_{SW2}.

In FIG. 2, the first gate current I_{G1} is subtracted at the negative input of the current sense comparator 120 and the second gate current I_{G2} is subtracted at the positive input of the comparator 120. The GaN switch devices GaN_{SW1}, GaN_{SW2} that form the voltage protection devices 116, 118 of the GaN die 100 automatically turn ON and OFF depending on the drain voltage of the sense and main GaN devices GaN_{POWER}, GaN_{SENSE}, respectively. When the GaN switch devices GaN_{SW1}, GaN_{SW2} are ON, the GaN switch devices GaN_{SW1}, GaN_{SW2} provide the exact voltage that is to be sensed. The respective external current sources drive the GaN switch devices GaN_{SW1}, GaN_{SW2} such that the gate and source of the GaN switch devices GaN_{SW1}, GaN_{SW2} can follow a large range of drain voltage for the GaN current sense transistor GaN_{SENSE}, which may occur when going from 0 current up to, e.g., 20A of overcurrent protection. This permits the gate and source of the GaN switch devices GaN_{SW1}, GaN_{SW2} to float with the drain of the GaN current sense transistor GaN_{SENSE} only up to the clamping voltage of the respective Zener diodes Z1, Z2. The clamped voltage protects the low voltage external current sense circuitry 114 from overvoltage breakdown.

The current that is injected into the gates of the GaN switch devices GaN_{SW1}, GaN_{SW2} that form the voltage protection devices 116, 118 of the GaN die 100 is also drawn out from the source so as to not impact the current sense accuracy. The embodiment shown in FIG. 2 consumes less current and is more accurate than the embodiment shown in FIG. 1. Also, to achieve higher accuracy, the RdsON*Isense drop across the second GaN switch device GaN_{SW2} may be compensated by injecting the Isense current into the first GaN switch device GaN_{SW1}, where RdsON is the device on-state resistance.

However, the GaN switch devices GaN_{SW1}, GaN_{SW2} in FIG. 2 consume power during the OFF state of the main GaN power transistor GaN_{POWER}. This can be mitigated by turning OFF the current sources that bias the GaN switch devices GaN_{SW1}, GaN_{SW2} in the OFF state, but this may require a slightly longer time to begin tracking again once the main GaN power transistor GaN_{POWER} is turned back ON.

The external current sense circuitry 114 that senses the current of the GaN die 100 with the high voltage protection may do so using the comparator 120 shown in FIGS. 1 and 2. Described next are additional embodiments of the external current sense circuitry 114 that may be used with GaN dies 100 shown in FIGS. 1 and 2 or with other types of power devices having a current readout. The following current sense are embodiments are described in the context of drain-side sensing of a low-side power switch device but may also be applied to source-side sensing.

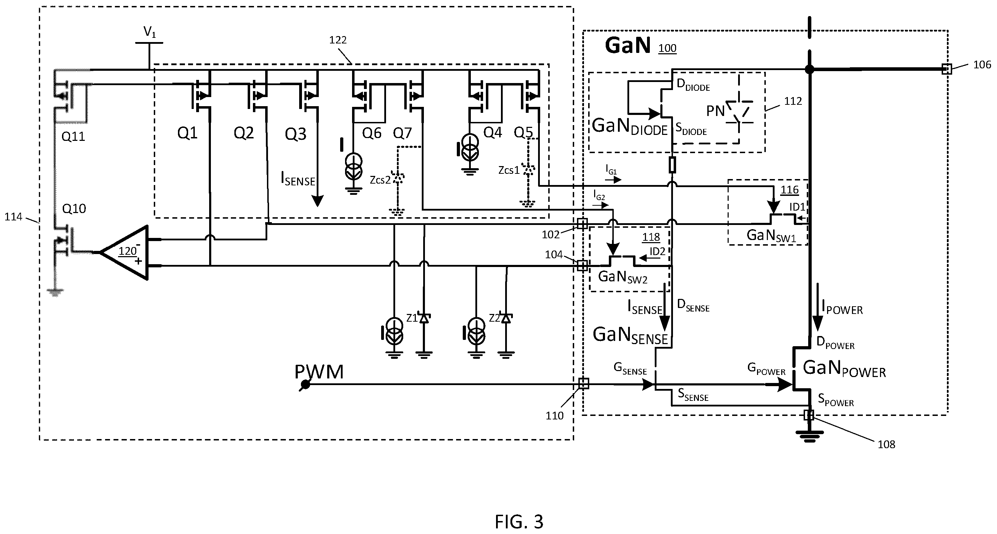

FIG. 3 illustrates an embodiment of the current sense circuitry 114. According to this embodiment, the output of the comparator 120 drives the gate of an nMOS transistor Q10 the drain of which is electrically connected to an additional pMOS transistor Q11 so as generate a current source which can be mirrored out and equalize the voltage across the inputs of the comparator 120.

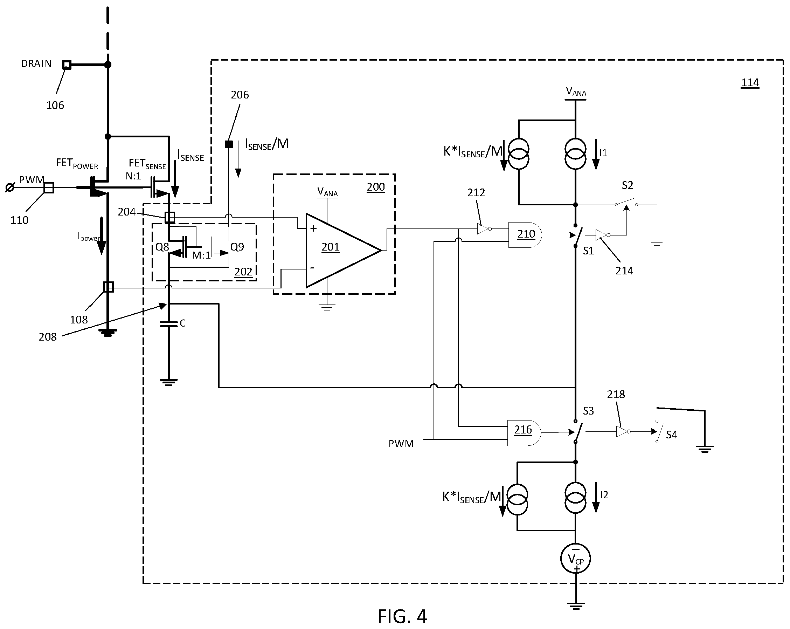

FIG. 4 illustrates an example not covered by the claims of a current sense circuitry 114. According to this example, the tracking behavior of the sense current is sped up during the ON phase of the main power transistor FET_{POWER}. The main power transistor FET_{POWER} may be the GaN power transistor GaN_{POWER} shown in FIGS. 1 or 2, or a different type of power transistor such as a power MOSFET (metal-oxide-semiconductor field-effect transistor). The current I_{SENSE} being sensed is a 1:N replica of the main power transistor current I_{POWER} and is provided by a sense transistor FET_{SENSE} on the same die as the main power transistor FET_{POWER}, where 1:N may be in a range of 1:2000 to 1:4000, for example. No overshoot or undershoot is expected in FIG. 4, because the control method implemented in FIG. 4 includes hysteretic control which uses the hysteresis of a comparator circuit 200.

In FIG. 4, the current sense circuitry 114 includes a reference diode / current mirror circuit 202 that inputs the sensed current I_{SENSE} from the sense transistor FET_{SENSE} at an input terminal 204 and provides a scaled-down (1:M) version I_{SENSE/M} of the sensed current I_{SENSE} at an output terminal 206. In the example, the power transistor FET_{POWER} is part of a low-side switch device, e.g., as shown in FIG. 1 or FIG. 2, such that the current I_{SENSE} input to the input terminal 204 of the reference diode / current mirror circuit 202 is a scaled-down (1:N) replica of the current flowing in a low-side power switch device. The output current I_{SENSE/M} of the current sense circuitry 114 is a fraction (1:M) of the current I_{SENSE} at the input terminal 204 of the reference diode / current mirror circuit 202. A capacitor C is directly connected to the reference diode / current mirror circuit 202 at a first node 208, and averages the current that is being sourced and sunk by first and second switched current sources 11, I2.

In FIG. 4, the current mirror circuit 202 includes a first transistor Q8 having a source terminal that corresponds to the input terminal 204 of the current mirror circuit 202, a gate terminal, and a drain terminal electrically connected to the gate terminal. The current mirror circuit 202 in FIG. 4 also includes a second transistor Q9 having a source terminal electrically connected to the source terminal of the first transistor Q8, a gate terminal electrically connected to the gate terminal of the first transistor Q8, and a drain terminal that corresponds to the output terminal 206 of the current mirror circuit 202.

The comparator circuit 200 of the current sense circuitry 114 in FIG. 4 has a first input electrically connected to the input terminal 204 of the reference diode / current mirror circuit 202, a second input electrically connected to the drain or source terminal of the power transistor power transistor FET_{POWER}, and an output that is in a first state when a voltage at the first input is higher than the voltage at the second input and in a second state when the voltage at the first input is lower than the voltage at the second input. In FIG. 4, the second input of the comparator circuit 200 is electrically connected to the source terminal of the power transistor FET_{POWER} and the comparator circuit 200 is implemented as a single comparator 201 having a positive (+) input as the first input and a negative (-) input as the second input.

The first switched current source I1 of the current sense circuitry 114 in FIG. 4 sources current to the first (capacitor) node 208 if the power transistor FET_{POWER} is on and the comparator output is in the second state. The second switched current source I2 sinks current from the first (capacitor) node 208 if the power transistor FET_{POWER} is on and the comparator output is in the first state. The capacitor C averages the current that is being sourced and sunk by the switched current sources I1, I2. This current is sensed by the reference diode / current mirror circuit 202 which makes the sensed current available as I_{SENSE/M}.

In FIG. 4, the negative input of the comparator circuit 200 is electrically connected to the source terminal of the power transistor FET_{POWER}, the first switched current source I1 includes a positive voltage source or charge pump V_{ANA}, and the second switched current source I2 includes a negative voltage source or charge pump V_{CP}. In another example, the negative input of the comparator circuit 200 is electrically connected to the drain terminal of the power transistor FET_{POWER} and both the first switched current source I1 and the second switched current source I2 each include a positive voltage source or charge pump V_{ANA}/V_{CP}.

To reduce current consumption and further speed up the tracking behavior of the current sense circuitry 114, a scaled version K*I_{SENSE/M} of the sensed current I_{SENSE/M} at the output terminal of the reference diode / current mirror circuit 202 is fed forward to the first switched current source I1 such that the current sourced to the first (capacitor) node 208 by the first switched current source I1 changes proportionally with the current I_{SENSE} at the input terminal 204.

The scaled version K*I_{SENSE/M} of the sensed current I_{SENSE/M} also is fed forward to the second switched current source I2 such that the current sunk from the first (capacitor) node 208 by the second switched current source I2 changes proportionally with the sensed current I_{SENSE} at the input terminal 204. The current consumption increases as the main transistor current I_{POWER} increases, and the current sense circuitry 114 in FIG. 4 can track I_{POWER} over a wide range of output currents, e.g., 0A up to 20A or higher. Also, the positive fed forward K*I_{SENSE/M} current permits the current tracking to occur much quicker as the fed forward K*I_{SENSE/M} causes the respective switched current sources I1, I2 to increase until reaching the corresponding target comparator value.

In FIG. 4, the first switched current source I1 is controlled by the output of the comparator circuit 200 and a gate signal PWM applied to the power transistor FET_{POWER}, e.g., via a first logic AND gate 210 and a first inverter 212, such that the first switched current source I1 sources current to the first (capacitor) node 208 if the gate signal PWM is active and the comparator output is in the second state. A first switch device S1 connects the first switched current source I1 to the first (capacitor) node 208 when the output of the first logic AND gate 210 is in a logic high state. A second switch device S2 and inverter 214 connect the first switched current source I1 to ground when the output of the first logic AND gate 210 is in a logic low state.

The second switched current source I2 is controlled by the output of the comparator circuit 200 and the gate signal PWM, e.g., via a second logic AND gate 216, such that the second switched current source I2 sinks current from the first (capacitor) node 208 if the gate signal PWM is active and the comparator output is in the first state. A third switch device S3 connects the second switched current source I2 to the first (capacitor) node 208 when the output of the second logic AND gate 216 is in a logic high state. A fourth switch device S4 and inverter 218 connect the second switched current source I2 to ground when the output of the second logic AND gate 216 is in a logic low state.

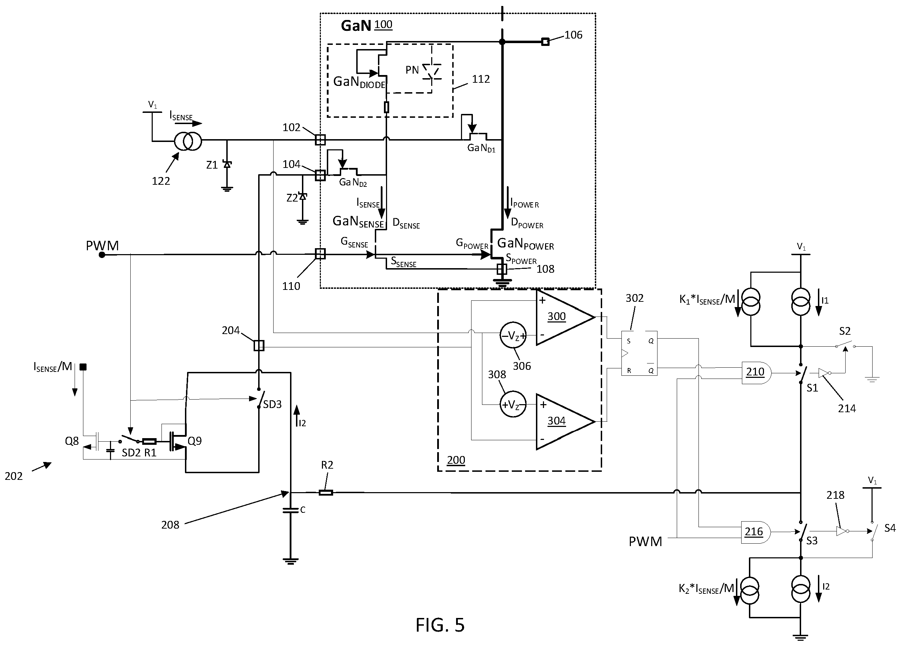

FIG. 5 illustrates another embodiment of the current sense circuitry 114 which is shown sensing the current I_{SENSE} from the GaN die 100 shown in FIG. 1. However, the current sense circuitry 114 in FIG. 5 may be used to sense the current of a different type of power transistor die such as a power MOSFET die.

In FIG. 5, the comparator circuit 200 is implemented as a dual comparator. The first comparator 300 has a positive input (+) electrically connected to the input terminal 204 of the current mirror circuit 202, a negative input (-) electrically connected to the drain terminal D_{POWER} of the main GaN power transistor GaN_{POWER}, and an output that drives a set input (S) of a latch 302. The second comparator 304 has a positive input (+) electrically connected to the drain terminal D_{POWER} of the main GaN power transistor GaN_{POWER}, a negative input (-) electrically connected to the input terminal 204 of the current mirror circuit 202, and an output that drives a reset input (R) of the latch 302. The first comparator 300 is for a defined upper edge and the second comparator 304 is for a defined lower edge, each comparator 300, 304 having an offset. The comparator offsets control the hysteresis which controls the width of voltage oscillation, yielding higher accuracy and improved peak current control. Use zeroing comparators 300, 304 where one comparator 300/304 runs and the other comparator 304/300 is zeroing reduces the offset error over the operational lifetime. A resistor R2 may be provided for attenuation.

In FIG. 5, the negative input (-) of the first comparator 300 and the positive input (+) of the second comparator 304 are electrically connected to the drain terminal D_{POWER} of the main GaN power transistor GaN_{POWER}. However, the negative input (-) of the first comparator 300 and the positive input (+) of the second comparator 304 instead may be electrically connected to the source terminal S_{POWER} of the main GaN power transistor GaN_{POWER}.

In FIG. 5, the comparator circuit 200 also includes a first hysteresis voltage source 306 electrically connected between the negative input (-) of the first comparator 300 and the drain (or source) terminal D_{POWER} of the main GaN power transistor GaN_{POWER} and a second hysteresis voltage source 308 electrically connected between the positive input (+) of the second comparator 304 and the drain (or source) terminal D_{POWER} of the main GaN power transistor GaN_{POWER}.

In FIG. 5, the gate terminal of the second transistor Q9 of the reference diode / current mirror circuit 202 is electrically connected to the gate terminal of the first transistor Q8 of the reference diode / current mirror circuit 202 by a switch device SD2 in series with a resistor R1. The switch device SD2 is controlled by the gate signal PWM applied to the main GaN power transistor GaN_{POWER} such that the switch device SD2 is closed when the gate signal PWM is active. An additional switch device SD3 controls the connection to the input terminal 204 of the current mirror circuit 202 and may be controlled by the gate signal PWM applied to the main GaN power transistor GaN_{POWER}, thus enabling a discrete current sense implementation.

In FIG. 5, diode devices GaN_{D1}, GaN_{D2} are used for high voltage protection and current sensing at the GaN die 100, and accurately track the drain voltage of the main GaN power transistor GaN_{POWER}. The diode devices GaN_{D1}, GaN_{D2} are faster than an op-amp but not as fast as sensing the source voltage of the main GaN power transistor GaN_{POWER} since it takes time for the drain and sense voltages to settle with the drain-side sensing.

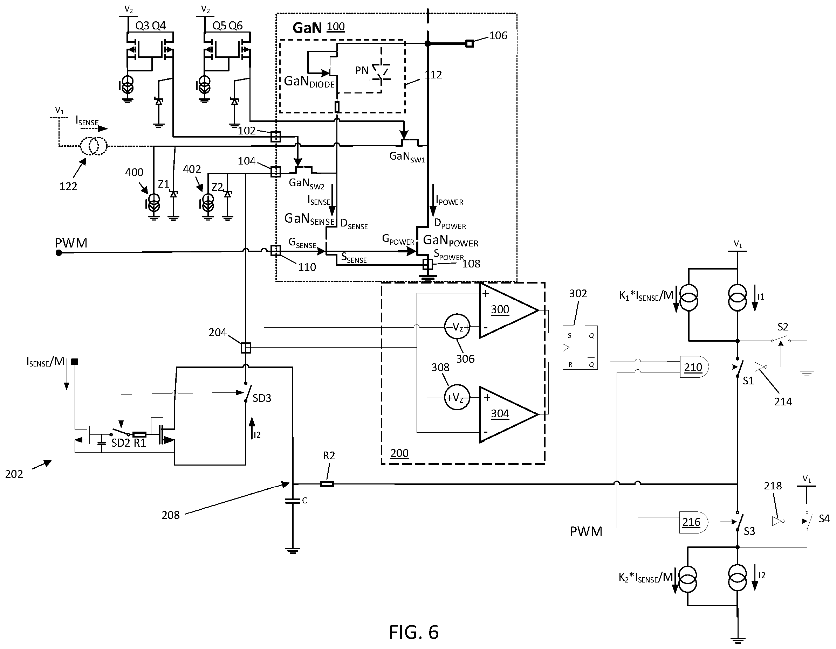

FIG. 6 illustrates another embodiment of the current sense circuitry 114 which is shown sensing the current I_{SENSE} from the GaN die 100 shown in FIG. 2. However, the current sense circuitry 114 in FIG. 6 may be used to sense the current of a different type of power transistor die such as a power MOSFET die.

As explained above, the voltage protection devices 116, 118 included in the GaN die 100 are implemented as respective GaN transistors GaN_{SW1}, GaN_{SW2} in FIG. 2. The first GaN transistors GaN_{SW1} is used exclusively as a switch device that is ON when the main GaN power transistor GaN_{POWER} is on and OFF when the main GaN power transistor GaN_{POWER} is off. The second GaN transistor GaN_{SW2} is used exclusively as a switch device that is ON when the GaN current sense transistor GaN_{SENSE} is on and OFF when the GaN current sense transistor GaN_{SENSE} is off. This non-linear control scheme accurately tracks the current I_{SENSE} and is very fast compared to an op-amp but as fast as sensing the source voltage due to the drain and sense voltage having to settle. The GaN switch devices GaN_{SW1}, GaN_{SW2} are clamped as the drain voltage of the main GaN power transistor GaN_{POWER} rises. The voltage of the GaN switch devices GaN_{SW1}, GaN_{SW2} is then brought back down to a lower voltage by a respective current source 400, 402 so that when either GaN switch device GaN_{SW1}, GaN_{SW2} turns back ON, the settling time is much shorter and the tracking is faster. The current sources 400, 402 may be shut off after a pulse to eliminate power dissipation at the GaN switch devices GaN_{SW1}, GaN_{SW2} during this phase.

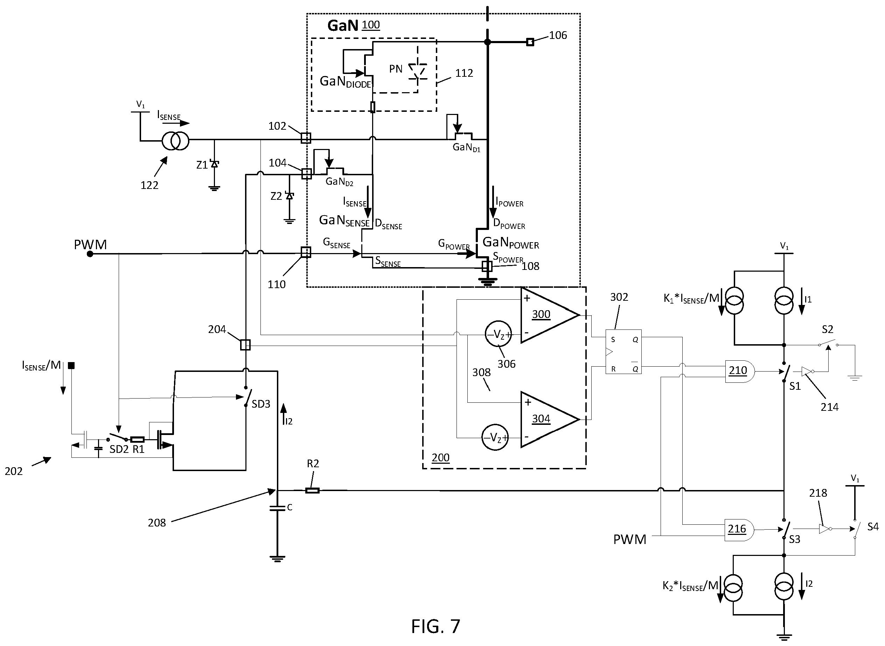

FIG. 7 illustrates another embodiment of the current sense circuitry 114 which is shown sensing the current I_{SENSE} from the GaN die 100 shown in FIG. 2. The embodiment illustrated in FIG. 6 is similar to the embodiment illustrated in FIG. 6, with the difference being the implementation of the hysteresis voltage sources 306, 308. In FIG. 7, which implements low-side current sensing, the hysteresis voltage sources 306, 308 provide a positive reference 'VZ' for both comparators 300, 304 compared to FIG. 6 in which the first hysteresis voltage source 306 provides a positive reference 'VZ' for the first comparator 300 and the second hysteresis voltage source 308 provides a negative reference 'VZ' for the second comparator 304.

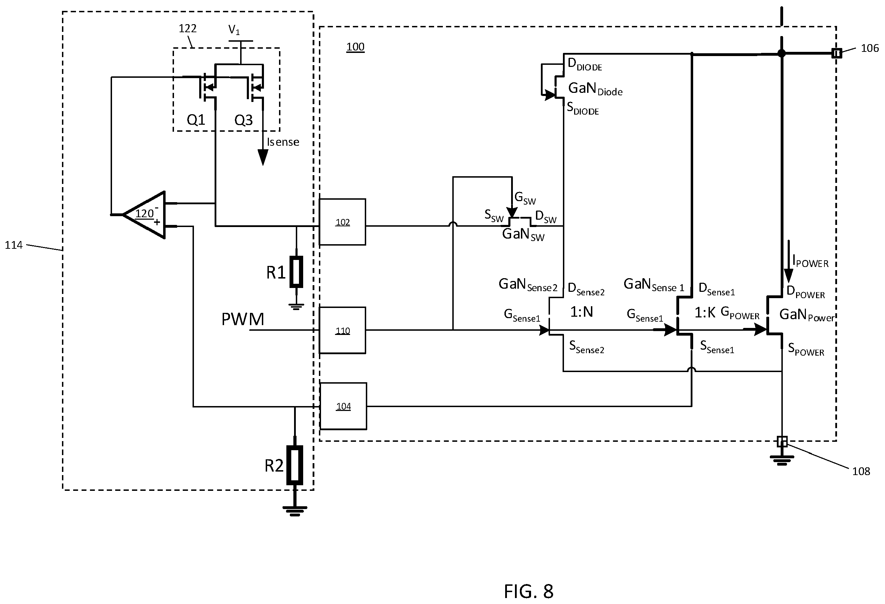

FIG. 8 illustrates another embodiment of the GaN die 100 and the external current sense circuitry 114. According to this embodiment, a first GaN current sense transistor GaN_{Sense1} is electrically connected between the drain D_{POWER} of the main GaN power transistor GaN_{POWER} and the second current sense terminal 104 and has a size ratio of 1:K compared to the main GaN power transistor GaN_{POWER}. A second GaN current sense transistor GaN_{Sense2} is electrically connected between the source S_{DIODE} of the HEMT-gated diode GaN_{DIODE} and the source S_{POWER} of the main GaN power transistor GaN_{POWER} and has a size ratio of 1:N compared to the main GaN power transistor GaN_{POWER}. A high voltage protection GaN transistor GaN_{SW} is electrically connected between the first current sense terminal 102 and the node between the source S_{DIODE} of the HEMT-gated diode GaN_{DIODE} and the drain D_{Sense2} of the second GaN current sense transistor GaN_{Sense2}. The gates G_{Sense1}, G_{Sense2} of the GaN current sense transistors GaN_{Sense1}, GaN_{Sense2} and the gate G_{SW} of the high voltage protection GaN transistor GaN_{SW} are each electrically connected to the gate terminal 110 of the GaN die 100 and therefore controlled by the same signal 'PWM' as the main GaN power transistor GaN_{POWER}.

The drain charge trapping phenomena of GaN-based high electron mobility transistors (HEMTs) is added to the second GaN current sense transistor GaN_{Sense2} and the high voltage protection GaN transistor GaN_{SW} by causing both devices GaN_{Sense2} and GaN_{SW} to see about the same drain voltage as the main GaN power transistor GaN_{POWER} during the OFF phase. In GaN technology, there is a minimum width beyond which matching becomes very poor. In FIG. 8, the Kilis factor is increased by including the high voltage protection GaN transistor GaN_{SW} and also using the high voltage protection GaN transistor GaN_{SW} as a sense device (which also has the same OFF phase drain stress), by matching to GaN_{Sense1}, GaN_{Sense2} and GaN_{POWER}. Such a configuration gives the added benefit that the sum of the two resistances RGaN_SW and RGaN_Sense2 of GaN_{SW} and GaNSense2 reduces the required sense current, and at the same time doubles the area that matches with the main GaN power transistor GaN_{POWER} and the other sense device GaN_{Sense1}. Therefore, the new N ratio becomes: $N ≅ \frac{{R}_{{GaN}_{SW}} + {R}_{{GaN}_{Sense 2}}}{{R}_{{GaN}_{Sense 1}}}$ where RGaN_Sense1 is the resistance of the first GaN current sense transistor GaN_{Sense1}.

Consequently, the resistor ratio is designed according to the N factor expressed in equation (1). Another benefit is that the temperature coefficient of the sense current may be varied with respect to the main GaN power transistor GaN_{POWER}. In this case, the temperature coefficients of the GaN current sense transistors GaN_{Sense1}, GaN_{Sense2} differ from the temperature coefficient of the main GaN power transistor GaN_{POWER} by changing the values of R1 and R2.

Also, the high voltage protection GaN transistor GaN_{SW} and the second GaN current sense transistor GaN_{Sense2} being in parallel to resistor R1 desensitizes the sense current from the aging effects of the high voltage protection GaN transistor GaN_{SW} and the second GaN current sense transistor GaN_{Sense2} because their variation does not cause such a significant impact on the final sense current as compared to the embodiments illustrated in FIGS. 3 and 4.

Furthermore, the current through the first GaN current sense transistor GaN_{Sense1} is used for the load and is not current being drawn out of an auxiliary supply such as V1. This allows for dimensioning of the first GaN current sense transistor GaN_{Sense1} to have large enough area for good matching and therefore a better GaN device trap charge distribution uniformity. The embodiment illustrated in FIG. 8 also enables bidirectional current sensing.

The current required for sensing may be minimized by dividing the power current by the factor K and N, where R1 = R2*N. The ratio N may be further increased by using both resistance RGaN_SW and RGaN_Sense2 as sense fingers. The high voltage protection GaN transistor GaN_{SW} is used both as a switch during the OFF phase to protect low voltage devices of the external current sense circuitry 114 and as a sense finger during the ON phase. Simulations have shown that smaller fingers have a different temperature coefficient as the main GaN power transistor GaN_{POWER}, however proper dimensioning of the resistors R1 and R2 allows for adjustment of the temperature coefficient.

The examples of the current sense circuitry 114 shown in FIGS. 1, 2, 3 and 8 may be used interchangeably. That is, the example of the current sense circuitry 114 shown in FIG. 1 may be replaced by the example of the current sense circuitry 114 shown in FIG. 2, 3, or 8, the example of the current sense circuitry 114 shown in FIG. 2 may be replaced by the example of the current sense circuitry 114 shown in FIG. 1, 3 or 8, the example of the current sense circuitry 114 shown in FIG. 3 may be replaced by the example of the current sense circuitry 114 shown in FIG. 1, 2 or 8, or the example of the current sense circuitry 114 shown in FIG. 8 may be replaced by the example of the current sense circuitry 114 shown in FIG. 1, 2, or 3.

Terms such as "first", "second", and the like, are used to describe various elements, regions, sections, etc. and are also not intended to be limiting. Like terms refer to like elements throughout the description.

The expression "and/or" should be interpreted to include all possible conjunctive and disjunctive combinations, unless expressly noted otherwise. For example, the expression "A and/or B" should be interpreted to mean only A, only B, or both A and B. The expression "at least one of" should be interpreted in the same manner as "and/or", unless expressly noted otherwise. For example, the expression "at least one of A and B" should be interpreted to mean only A, only B, or both A and B.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

It is to be understood that the features of the various embodiments described herein may be combined with each other, unless specifically noted otherwise.

## Claims

1. A GaN, gallium nitride, die (100), comprising:
a first current sense terminal (102);
a second current sense terminal (104);
a main GaN power transistor (GaN_{POWER});
a GaN current sense transistor (GaN_{SENSE}) having a source (S_{SENSE}) electrically connected to a source (S_{POWER}) of the main GaN power transistor (GaN_{POWER});
a diode device (112) electrically connected in series in forward direction between a drain (D_{POWER}) of the main GaN power transistor (GaN_{POWER}) and a drain (D_{SENSE}) of the GaN current sense transistor (GaN_{SENSE});
a first voltage protection device (116) electrically connecting the drain (D_{POWER}) of the main GaN power transistor (GaN_{POWER}) to the first current sense terminal (102); and
a second voltage protection device (118) electrically connecting the drain (D_{SENSE}) of the GaN current sense transistor (GaN_{SENSE}) to the second current sense terminal (104), wherein
the GaN die (100) provides high voltage protection for an external current sense circuit to be electrically connected to the first and second current sense terminals of the GaN die (100), and wherein
a) the first voltage protection device (116) is a first GaN transistor (GaN_{D1}) having a drain electrically connected to the drain (D_{POWER}) of the main GaN power transistor (GaN_{POWER}), a source electrically connected to the first current sense terminal (102), and a gate electrically connected to the source of the first GaN transistor (GaN_{D1}), and wherein the second voltage protection device (118) is a second GaN transistor (GaN_{D2}) having a drain electrically connected to the drain (D_{SENSE}) of the GaN current sense transistor (GaN_{SENSE}), a source electrically connected to the second current sense terminal (104), and a gate electrically connected to the source of the second GaN transistor (GaN_{D2}), or
b) the first voltage protection device (116) is a first GaN transistor (GaN_{SW1}) used exclusively as a switch device and configured to be on when the main GaN power transistor (GaN_{POWER}) is on and to be off when the main GaN power transistor (GaN_{POWER}) is off, and wherein the second voltage protection device (118) is a second GaN transistor (GaN_{SW2}) used exclusively as a switch device and configured to be on when the GaN current sense transistor (GaN_{SENSE}) is on and to be off when the GaN current sense transistor (GaN_{SENSE}) is off.

2. The GaN die (100) of claim 1, wherein a channel width of the GaN current sense transistor (GaN_{SENSE}) is in a range of 1:2000 to 1:4000 of a channel width of the main GaN power transistor (GaN_{POWER}).

3. The GaN die (100) of claim 1 or 2, wherein
the diode device (112) is a GaN transistor (GAN_{DIODE}) having a drain (D_{DIODE}) electrically connected to the drain (D_{POWER}) of the main GaN power transistor (GaN_{POWER}), a source (S_{DIODE}) electrically connected to the drain (D_{SENSE}) of the GaN current sense transistor (GaN_{SENSE}), and a gate electrically connected to the drain (D_{DIODE}) of the GaN transistor (GaN_{DIODE}), or
the diode device (112) is a pn diode (PN) having an anode electrically connected to the drain (D_{POWER}) of the main GaN power transistor (GaN_{POWER}) and a cathode electrically connected to the drain (D_{SENSE}) of the GaN current sense transistor (GaN_{SENSE}).

4. The GaN die (100) of one of claims 1 to 3, wherein each of the main GaN power transistor (GaN_{POWER}), the GaN current sense transistor (GaN_{SENSE}), the first voltage protection device (116), and the second voltage protection device (118) is a Schottky-gate HEMT, high electron mobility transistor, device.

5. A power electronics device, comprising:
a GaN die (100) of one of claims 1 to 4; and
a current sense circuit (114) electrically connected to the first and second current sense terminals (102, 104),
wherein the first voltage protection device (116) is configured to protect the current sense circuit (114) from the full drain voltage of the main GaN power transistor (GaN_{POWER}) and the second voltage protection device (118) is configured to protect the current sense circuit (114) from the full drain voltage of the GaN current sense transistor (GaN_{SENSE}).

6. The power electronics device of claim 5, comprising feature b) and wherein the current sense circuit (114) comprises:
a comparator (120) having a first input electrically connected to the first current sense terminal (102) and a second input electrically connected to the second current sense terminal (104); and
a current source circuit (122) controlled by an output of the comparator (120) and configured to force a current through the first voltage protection device (116) and that minimizes a voltage difference across the first and second current sense terminals (102, 104).

7. The power electronics device of claim 6, wherein the first voltage protection device (116) is a first diode device electrically connected to the first input of the comparator (120) via the first current sense terminal (102), wherein the second voltage protection device (118) is a second diode device electrically connected to the second input of the comparator (120) via the second current sense terminal (104), and wherein the current source circuit (122) is configured to set a first current (ID1) that flows through the first diode device and a second current (ID2) that flows through the second diode device, based on the comparator output.

8. The power electronics device of claim 7, wherein the current sense circuit (114) comprises:
a first Zener diode (Z1) configured to clamp the voltage at the first current sense terminal (102); and
a second Zener diode (Z2) configured to clamp the voltage at the second current sense terminal (104).

9. The power electronics device of claim 6, comprising feature b) and wherein the first voltage protection device (116) is a first GaN switch device (GaN_{SW1}) having a drain electrically connected to the drain (D_{POWER}) of the main GaN power transistor (GaN_{POWER}) and a source electrically connected to the first current sense terminal (102), wherein the second voltage protection device (118) is a second GaN switch device (GaN_{SW2}) having a drain electrically connected to the drain (D_{SENSE}) of the GaN current sense transistor (GaN_{SENSE}) and a source electrically connected to the second current sense terminal (104), and wherein the current source circuit (122) is configured to set a first current (ID1) that flows through the first GaN switch device (GaN_{SW1}) and a second current (ID2) that flows through the second GaN switch device (GaN_{SW2}), based on the comparator output.

10. The power electronics device of claim 7 or 9, wherein the current source circuit (122) comprises:
a first pMOS transistor (Q1) controlled by the output of the comparator (120) and having a source electrically connected to a voltage source (V₁) and a drain electrically connected to the second current sense terminal (104);
a second pMOS transistor (Q2) controlled by the output of the comparator (120) and having a source electrically connected to the voltage source (V₁) and a drain electrically connected to the first current sense terminal (102); and
a third pMOS transistor (Q3) controlled by the output of the comparator (120) and having a source electrically connected to the voltage source (V₁) and a drain that forms a current sense output of the current sense circuit (114).

11. The power electronics device of claim 9, wherein the current source circuit (122) comprises:
a first current source (Q1, Q2) configured to inject a first gate current into a gate of the first GaN switch device (GaN_{SW1}); and
a second current source (Q6, Q7) configured to inject a second gate current into a gate of the second GaN switch device (GaN_{SW2}),
wherein the first gate current is subtracted at the first input of the comparator (120),
wherein the second gate current is subtracted at the second input of the comparator (120).

12. The power electronics device of claim 9, wherein the current sense circuit (114) comprises:
a first Zener diode (Z1) electrically connected to the first current sense terminal (102); and
a second Zener diode (Z2) electrically connected to the second current sense terminal (104),
wherein the gate and the source of the first GaN switch device (GaN_{SW1}) float with the drain (D_{POWER}) of the main GaN power transistor (GaN_{POWER}) up to a clamping voltage of the first Zener diode (Z1),
wherein the gate and the source of the second GaN switch device (GaN_{SW2}) float with the drain (D_{SENSE}) of the GaN current sense transistor (GaN_{SENSE}) up to a clamping voltage of the second Zener diode (Z2).

13. The power electronics device of one of claims 5 to 12, wherein each of the main GaN power transistor (GaN_{POWER}), the GaN current sense transistor (GaN_{SENSE}), the first voltage protection device (116), and the second voltage protection device (118) is a Schottky-gate HEMT, high electron mobility transistor, device, and wherein the current sense circuit (114) is implemented in silicon.

## Patentansprüche

1. Ein GaN-, Galliumnitrid-, Chip (100), der folgende Merkmale aufweist:
einen ersten Stromerfassungsanschluss (102);
einen zweiten Stromerfassungsanschluss (104);
einen Haupt-GaN-Leistungstransistor (GaN_{POWER});
einen GaN-Stromerfassungstransistor (GaN_{SENSE}), der eine Source (S_{SENSE}) aufweist, die mit einer Source (S_{POWER}) des Haupt-GaN-Leistungstransistors (GaN_{POWER}) elektrisch verbunden ist;
ein Diodenbauelement (112), das in Vorwärtsrichtung zwischen einen Drain (D_{POWER}) des Haupt-GaN-Leistungstransistors (GaN_{POWER}) und einen Drain (D_{SENSE}) des GaN-Stromerfassungstransistors (GaN_{SENSE}) elektrisch in Reihe geschaltet ist;
ein erstes Spannungsschutzbauelement (116), das den Drain (D_{POWER}) des Haupt-GaN-Leistungstransistors (GaN_{POWER}) mit dem ersten Stromerfassungsanschluss (102) elektrisch verbindet; und
ein zweites Spannungsschutzbauelement (118), das den Drain (D_{SENSE}) des GaN-Stromerfassungstransistors (GaN_{SENSE}) mit dem zweiten Stromerfassungsanschluss (104) elektrisch verbindet, wobei
der GaN-Chip (100) einen Hochspannungsschutz für eine externe Stromerfassungsschaltung bereitstellt, die mit dem ersten und dem zweiten Stromerfassungsanschluss des GaN-Chips (100) elektrisch zu verbinden ist, und wobei
a) das erste Spannungsschutzbauelement (116) ein erster GaN-Transistor (GaN_{D1}) ist, der einen Drain, der mit dem Drain (D_{POWER}) des Haupt-GaN-Leistungstransistors (GaN_{POWER}) elektrisch verbunden ist, eine Source, die mit dem ersten Stromerfassungsanschluss (102) elektrisch verbunden ist, und ein Gate aufweist, das mit der Source des ersten GaN-Transistors (GaN_{D1}) elektrisch verbunden ist, und wobei das zweite Spannungsschutzbauelement (118) ein zweiter GaN-Transistor (GaN_{D2}) ist, der einen Drain, der mit dem Drain (D_{SENSE}) des GaN-Stromerfassungstransistors (GaN-_{SENSE}) elektrisch verbunden ist, eine Source, die mit dem zweiten Stromerfassungsanschluss (104) elektrisch verbunden ist, und ein Gate aufweist, das mit der Source des zweiten GaN-Transistors (GaN_{D2}) elektrisch verbunden ist, oder
b) das erste Spannungsschutzbauelement (116) ein erster GaN-Transistor (GaN_{SW1}) ist, der ausschließlich als ein Schaltbauelement verwendet wird und dazu konfiguriert ist, eingeschaltet zu sein, wenn der Haupt-GaN-Leistungstransistor (GaN_{POWER}) eingeschaltet ist, und ausgeschaltet zu sein, wenn der Haupt-GaN-Leistungstransistor (GaN_{POWER}) ausgeschaltet ist, und wobei das zweite Spannungsschutzbauelement (118) ein zweiter GaN-Transistor (GaN_{SW2}) ist, der ausschließlich als ein Schaltbauelement verwendet wird und dazu konfiguriert ist, eingeschaltet zu sein, wenn der GaN-Stromerfassungstransistor (GaN_{SENSE}) eingeschaltet ist, und ausgeschaltet zu sein, wenn der GaN-Stromerfassungstransistor (GaN_{SENSE}) ausgeschaltet ist.

2. Der GaN-Chip (100) gemäß Anspruch 1, wobei eine Kanalbreite des GaN-Stromerfassungstransistors (GaN_{SENSE}) in einem Bereich von 1:2000 bis 1:4000 einer Kanalbreite des Haupt-GaN-Leistungstransistors (GaN_{POWER}) liegt.

3. Der GaN-Chip (100) gemäß Anspruch 1 oder 2, wobei
das Diodenbauelement (112) ein GaN-Transistor (GaN_{DIODE}) ist, der einen Drain (D_{DIODE}), der mit dem Drain (D_{POWER}) des Haupt-GaN-Leistungstransistors (GaN_{POWER}) elektrisch verbunden ist, eine Source (S_{DIODE}), die mit dem Drain (D_{SENSE}) des GaN-Stromerfassungstransistors (GaN_{SENSE}) elektrisch verbunden ist, und ein Gate aufweist, das mit dem Drain (D_{DIODE}) des GaN-Transistors (GaN_{DIODE}) elektrisch verbunden ist, oder
das Diodenbauelement (112) eine pn-Diode (PN) ist, die eine Anode, die mit dem Drain (D_{POWER}) des Haupt-GaN-Leistungstransistors (GaN_{POWER}) elektrisch verbunden ist, und eine Kathode aufweist, die mit dem Drain (D_{SENSE}) des GaN-Stromerfassungstransistors (GaN_{SENSE}) elektrisch verbunden ist.

4. Der GaN-Chip (100) gemäß einem der Ansprüche 1 bis 3, wobei jeder/s von dem Haupt-GaN-Leistungstransistor (GaN_{POWER}), dem GaN-Stromerfassungstransistor (GaN-_{SENSE}), dem ersten Spannungsschutzbauelement (116) und dem zweiten Spannungsschutzbauelement (118) ein Schottky-Gate-HEMT-Bauelement (HEMT = Transistor mit hoher Elektronenmobilität) ist.

5. Ein Leistungselektronikbauelement, das folgende Merkmale aufweist:
einen GaN-Chip (100) gemäß einem der Ansprüche 1 bis 4; und
eine Stromerfassungsschaltung (114), die mit dem ersten und dem zweiten Stromerfassungsanschluss (102, 104) elektrisch verbunden ist,
wobei das erste Spannungsschutzbauelement (116) dazu konfiguriert ist, die Stromerfassungsschaltung (114) vor der vollen Drain-Spannung des Haupt-GaN-Leistungstransistors (GaN_{POWER}) zu schützen, und das zweite Spannungsschutzbauelement (118) dazu konfiguriert ist, die Stromerfassungsschaltung (114) vor der vollen Drain-Spannung des GaN-Stromerfassungstransistors (GaN_{SENSE}) zu schützen.

6. Das Leistungselektronikbauelement gemäß Anspruch 5, das Merkmal b) aufweist, und wobei die Stromerfassungsschaltung (114) folgende Merkmale aufweist:
einen Komparator (120) mit einem ersten Eingang, der mit dem ersten Stromerfassungsanschluss (102) elektrisch verbunden ist, und einem zweiten Eingang, der mit dem zweiten Stromerfassungsanschluss (104) elektrisch verbunden ist; und
eine Stromquellenschaltung (122), die durch einen Ausgang des Komparators (120) gesteuert wird und dazu konfiguriert ist, einen Strom durch das erste Spannungsschutzbauelement (116) zu zwingen, und die eine Spannungsdifferenz über dem ersten und dem zweiten Stromerfassungsanschluss (102, 104) minimiert.

7. Das Leistungselektronikbauelement gemäß Anspruch 6, wobei das erste Spannungsschutzbauelement (116) ein erstes Diodenbauelement ist, das mit dem ersten Eingang des Komparators (120) über den ersten Stromerfassungsanschluss (102) elektrisch verbunden ist, wobei das zweite Spannungsschutzbauelement (118) ein zweites Diodenbauelement ist, das mit dem zweiten Eingang des Komparators (120) über den zweiten Stromerfassungsanschluss (104) elektrisch verbunden ist, und wobei die Stromquellenschaltung (122) dazu konfiguriert ist, einen ersten Strom (ID1), der durch das erste Diodenbauelement fließt, und einen zweiten Strom (ID2), der durch das zweite Diodenbauelement fließt, basierend auf dem Komparatorausgang einzustellen.

8. Das Leistungselektronikbauelement gemäß Anspruch 7, wobei die Stromerfassungsschaltung (114) folgende Merkmale aufweist:
eine erste Zenerdiode (Z1), die dazu konfiguriert ist, die Spannung an dem ersten Stromerfassungsanschluss (102) zu klemmen; und
eine zweite Zenerdiode (Z2), die dazu konfiguriert ist, die Spannung an dem zweiten Stromerfassungsanschluss (104) zu klemmen.

9. Das Leistungselektronikbauelement gemäß Anspruch 6, das Merkmal b) aufweist, und wobei das erste Spannungsschutzbauelement (116) ein erstes GaN-Schaltbauelement (GaN_{SW1}) ist, das einen Drain, der mit dem Drain (D_{POWER}) des Haupt-GaN-Leistungstransistors (GaN_{POWER}) elektrisch verbunden ist, und eine Source aufweist, die mit dem ersten Stromerfassungsanschluss (102) elektrisch verbunden ist, wobei das zweite Spannungsschutzbauelement (118) ein zweites GaN-Schaltbauelement (GaN_{SW2}) ist, das einen Drain, der mit dem Drain (D_{SENSE}) des GaN-Stromerfassungstransistors (GaN_{SENSE}) elektrisch verbunden ist, und eine Source aufweist, die mit dem zweiten Stromerfassungsanschluss (104) elektrisch verbunden ist, und wobei die Stromquellenschaltung (122) dazu konfiguriert ist, einen ersten Strom (ID1), der durch das erste GaN-Schaltbauelement (GaN_{SW1)} fließt, und einen zweiten Strom (ID2), der durch das zweite GaN-Schaltbauelement (GaN_{SW2}) fließt, basierend auf dem Komparatorausgang einzustellen.

10. Das Leistungselektronikbauelement gemäß Anspruch 7 oder 9, wobei die Stromquellenschaltung (122) folgende Merkmale aufweist:
einen ersten pMOS-Transistor (Q1), der durch den Ausgang des Komparators (120) gesteuert wird und eine Source, die mit einer Spannungsquelle (V₁) elektrisch verbunden ist, und einen Drain aufweist, der mit dem zweiten Stromerfassungsanschluss (104) elektrisch verbunden ist;
einen zweiten pMOS-Transistor (Q2), der durch den Ausgang des Komparators (120) gesteuert wird und eine Source, die mit der Spannungsquelle (V₁) elektrisch verbunden ist, und einen Drain aufweist, der mit dem ersten Stromerfassungsanschluss (102) elektrisch verbunden ist; und
einen dritten pMOS-Transistor (Q3), der durch den Ausgang des Komparators (120) gesteuert wird und eine Source, die mit der Spannungsquelle (V₁) elektrisch verbunden ist, und einen Drain aufweist, der einen Stromerfassungsausgang der Stromerfassungsschaltung (114) bildet.

11. Das Leistungselektronikbauelement gemäß Anspruch 9, wobei die Stromquellenschaltung (122) folgende Merkmale aufweist:
eine erste Stromquelle (Q1, Q2), die dazu konfiguriert ist, einen ersten Gate-Strom in ein Gate des ersten GaN-Schaltbauelements (GaN_{SW1}) zu injizieren; und
eine zweite Stromquelle (Q6, Q7), die dazu konfiguriert ist, einen zweiten Gate-Strom in ein Gate des zweiten GaN-Schaltbauelements (GaN_{SW2}) zu injizieren,
wobei der erste Gate-Strom an dem ersten Eingang des Komparators (120) subtrahiert wird,
wobei der zweite Gate-Strom an dem zweiten Eingang des Komparators (120) subtrahiert wird.

12. Das Leistungselektronikbauelement gemäß Anspruch 9, wobei die Stromerfassungsschaltung (114) folgende Merkmale aufweist:
eine erste Zenerdiode (Z1), die mit dem ersten Stromerfassungsanschluss (102) elektrisch verbunden ist; und
eine zweite Zenerdiode (Z2), die mit dem zweiten Stromerfassungsanschluss (104) elektrisch verbunden ist,
wobei das Gate und die Source des ersten GaN-Schaltbauelements (GaN_{SW1}) mit dem Drain (D_{POWER}) des Haupt-GaN-Leistungstransistors (GaN_{POWER}) bis zu einer Klemmspannung der ersten Zenerdiode (Z1) floaten,
wobei das Gate und die Source des zweiten GaN-Schaltbauelements (GaN_{SW2}) mit dem Drain (D_{SENSE}) des GaN-Stromerfassungstransistors (GaN_{SENSE}) bis zu einer Klemmspannung der zweiten Zenerdiode (Z2) floaten.

13. Das Leistungselektronikbauelement gemäß einem der Ansprüche 5 bis 12, wobei jeder/s von dem Haupt-GaN-Leistungstransistor (GaN_{POWER}), dem GaN-Stromerfassungstransistor (GaN_{SENSE}), dem ersten Spannungsschutzbauelement (116) und dem zweiten Spannungsschutzbauelement (118) ein Schottky-Gate-HEMT-Bauelement (HEMT = Transistor mit hoher Elektronenmobilität) ist, und wobei die Stromerfassungsschaltung (114) in Silizium implementiert ist.

## Revendications

1. Une puce (100) au GaN, nitrure de gallium, comprenant :
une première borne (102) de détection de courant ;
une deuxième borne (104) de détection de courant ;
un transistor (GaN_{POWER}) principal de puissance au GaN ;
un transistor (GaN_{SENSE}) de détection de courant au GaN ayant une source (S_{SENSE}) connectée électriquement à une source (S_{POWER}) du transistor (GaN_{POWER}) principal de puissance au GaN ;
un dispositif (112) à diode monté électriquement en série dans le sens direct entre un drain (D_{POWER}) du transistor (GaN_{POWER}) principal de puissance au GaN et un drain (D_{SENSE}) du transistor (GaN_{SENSE}) de détection de courant au GaN ;
un premier dispositif (116) de protection de la tension connectant électriquement le drain (D_{POWER}) du transistor (GaN_{POWER}) principal de puissance au GaN à la première borne (102) de détection de courant ;
et
un deuxième dispositif (118) de protection de la tension connectant électriquement le drain (D_{SENSE}) du transistor (GaN_{SENSE}) de détection de courant au GaN à la deuxième borne (104) de détection de courant, dans laquelle
la puce (100) au GaN donne une protection à la haute tension pour un circuit extérieur de détection de courant à connecter électriquement aux première et deuxième bornes de détection de courant de la puce (100) au GaN, et dans laquelle
a) le premier dispositif (116) de protection de la tension est un premier transistor (GaN_{D1}) au GaN ayant un drain connecté au drain (D_{POWER}) du transistor (GaN_{POWER}) principal de puissance au GaN, une source connectée électriquement à la première borne (102) de détection de courant et une grille connectée électriquement à la source du premier transistor (GaN_{D1}) au GaN, et dans laquelle le deuxième dispositif (118) de protection de la tension est un deuxième transistor (GaN_{D2}) au GaN ayant un drain connecté électriquement au drain (D_{SENSE}) du transistor (GaN_{SENSE}) de détection de courant au GaN, une source connectée électriquement à la deuxième borne (104) de détection de courant et une grille connectée électriquement à la source du deuxième transistor (GaN_{D2}) au GaN, ou
b) le premier dispositif (116) de protection de la tension est un premier transistor (GaN_{SW1}) au GaN utilisé exclusivement comme un dispositif de coupure et configuré pour être fermé, lorsque le transistor (GaN_{POWER}) principal de puissance au GaN est passant, et pour être ouvert, lorsque le transistor (GaN_{POWER}) principal de puissance au GaN est bloqué, et dans laquelle le deuxième dispositif (118) de protection de la tension est un deuxième transistor (GaN_{SW2}) au GaN utilisé exclusivement comme dispositif de coupure et configuré pour être fermé, lorsque le transistor (GaN_{SENSE}) de détection de courant au GaN est passant, et pour être ouvert, lorsque le transistor (GaN_{SENSE}) de détection de courant au GaN est bloqué.

2. La puce (100) au GaN de la revendication 1, dans laquelle une largeur de canal du transistor (GaN_{SENSE}) de détection de . courant au GaN est dans une plage de 1:2000 à 1:4000 d'une largeur de canal du transistor (GaN_{POWER}) principal de puissance au GaN.

3. La puce (100) au GaN de la revendication 1 ou 2, dans laquelle
le dispositif (112) à diode est un transistor (GaN_{DIODE}) au GaN ayant un drain (D_{DIODE}) connecté électriquement au drain (D_{POWER}) du transistor (GaN_{POWER}) principal de puissance au GaN, une source (S_{DIODE}) connectée électriquement au drain (D_{SENSE}) du transistor (GaN_{SENSE}) de détection de courant au GaN et une grille connectée électriquement au drain (D_{DIODE}) du transistor (GaN_{DIODE}) au GaN, ou
le dispositif (112) à diode est une diode pn (PN) ayant une anode connectée électriquement au drain (D_{POWER}) du transistor (GaN_{POWER}) principal de puissance au GaN et une cathode connectée électriquement au drain (D_{SENSE}) du transistor (GaN_{SENSE}) de détection de courant au GaN.

4. La puce (100) au GaN de l'une des revendications 1 à 3, dans laquelle chacun du transistor (GaN_{POWER}) principal de puissance au GaN, du transistor (GaN_{SENSE}) de détection de courant au GaN, du premier dispositif (116) de protection de la tension et du deuxième dispositif (118) de protection de la tension est un dispositif HEMT, transistor à grande mobilité d'électron, à grille de Schottky.

5. Un dispositif d'électronique de puissance, comprenant :
une puce (100) au GaN de l'une des revendications 1 à 4 ; et
un circuit (114) de détection de courant connecté électriquement à la première et à la deuxième borne (102, 104) de détection de courant,
dans lequel le premier dispositif (116) de protection de la tension est configuré pour protéger le circuit (114) de détection de courant de la tension pleine de drain . du transistor (GaN_{POWER}) principal de puissance au GaN et le deuxième dispositif (118) de protection de la tension est configuré pour protéger le circuit (114) de détection de courant de la tension pleine de drain du transistor (GaN_{SENSE}) de détection de courant au GaN.

6. Le dispositif d'électronique de puissance de la revendication 5, comprenant la caractéristique b), et dans lequel le circuit (114) de détection de courant comprend :
un comparateur (120) ayant une première entrée connectée électriquement à la première borne (102) de détection de courant et une deuxième entrée connectée électriquement à la deuxième borne (104) de détection de courant ; et
un circuit (122) de source de courant commandé par une sortie du comparateur (120) et configuré pour forcer un courant dans le premier dispositif (116) de protection de la tension et qui minimise une différence de tension aux bornes des première et deuxième bornes (102, 104) de détection de courant.

7. Le dispositif d'électronique de puissance de la revendication 6, dans lequel le premier dispositif (116) de protection de la tension est un premier dispositif à diode connecté électriquement à la première entrée du comparateur (120) par l'intermédiaire de la première borne (102) de détection de courant, dans lequel le deuxième dispositif (118) de protection de la tension est un deuxième dispositif à diode connecté électriquement à la deuxième entrée du comparateur (120) par l'intermédiaire de la deuxième borne (104) de détection de courant, et dans lequel le circuit (122) de source de courant est configuré pour régler un premier courant (ID1), qui passe dans le premier dispositif à diode et un deuxième courant (ID2), qui passe dans le deuxième dispositif à diode, sur la base de la sortie du comparateur. .

8. Le dispositif d'électronique de puissance de la revendication 7, dans lequel le circuit (114) de détection de courant comprend :
une première diode (Z1) Zener configurée pour fixer le niveau de la tension à la première borne (102) de détection de courant ; et
une deuxième diode (Z2) Zener configurée pour fixer le niveau de la tension à la deuxième borne (104) de détection de courant.

9. Le dispositif d'électronique de puissance de la revendication 6, comprenant la caractéristique b), et dans lequel le premier dispositif (116) de protection de la tension est un premier dispositif (GaN_{SW1}) interrupteur au GaN ayant un drain connecté électriquement au drain (D_{POWER}) du transistor (GaN_{POWER}) principal de puissance au GaN et une source connectée électriquement à la première borne (102) de détection de courant, dans lequel le deuxième dispositif (118) de protection de la tension est un deuxième dispositif (GaN_{SW2}) de coupure au GaN ayant un drain connecté électriquement au drain (D_{SENSE}) du transistor (GaN_{SENSE}) de détection de courant au GaN et une source connectée électriquement à la deuxième borne (104) de détection de courant, et dans lequel le circuit (122) de source de courant est configuré pour régler le premier courant (ID1), qui passe dans le premier dispositif (GaN_{SW1}) de coupure au GaN et un deuxième courant (ID2), qui passe dans le deuxième dispositif (GaN_{SW2}) de coupure au GaN, sur la base de la sortie du comparateur.

10. Le dispositif d'électronique de puissance de la revendication 7 ou 9, dans lequel le circuit (122) de source de courant comprend :
un premier transistor (Q1) pMOS commandé par la sortie du comparateur (120) et ayant une source connectée . électriquement à une source (V₁) de tension et un drain connecté électriquement à la deuxième borne (104) de détection de courant ;
un deuxième transistor (Q2) pMOS commandé par la sortie du comparateur (120) et ayant une source connectée électriquement à la source (V₁) de tension et un drain connecté électriquement à la première borne (102) de détection de courant ; et
un troisième transistor (Q3) pMOS commandé par la sortie du comparateur (120) et ayant une source connectée électriquement à la source (V₁) de tension et un drain, qui forme une sortie de détection de courant du circuit (114) de détection de courant.

11. Le dispositif d'électronique de puissance de la revendication 9, dans lequel le circuit (122) de source de courant comprend :
une première source (Q1, Q2) de courant configurée pour injecter un premier courant de grille dans une grille du premier dispositif (GaN_{SW1}) de coupure au GaN ; et
une deuxième source (Q6, Q7) de courant configurée pour injecter un deuxième courant de grille dans une grille du deuxième dispositif (GaN_{SW2}) de coupure au GaN,
dans lequel le premier courant de grille est soustrait à la première entrée du comparateur (120),
dans lequel le deuxième courant de grille est soustrait à la deuxième entrée du comparateur (120).

12. Le dispositif d'électronique de puissance de la revendication 9, dans lequel le circuit (114) de détection de courant comprend :
une première diode (Z1) Zener connectée électriquement à la première borne (102) de détection de courant ;
et .
une deuxième diode (Z2) Zener connectée électriquement à la deuxième borne (104) de détection de courant,
dans lequel la grille et la source du premier dispositif (GaN_{SW1}) de coupure au GaN flottent avec le drain (D_{POWER}) du transistor (GaN_{POWER}) principal de puissance au GaN jusqu'à une tension de mise à niveau de la première diode (Z1) Zener,
dans lequel la grille et la source du deuxième dispositif (GaN_{SW2}) de coupure au GaN flottent avec le drain (D_{SENSE}) du transistor (GaN_{SENSE}) de détection de courant au GaN jusqu'à une tension de mise à niveau de la deuxième diode (Z2) Zener.

13. Le dispositif d'électronique de puissance de l'une des revendications 5 à 12, dans lequel chacun du transistor (GaN_{POWER}) principal de puissance au GaN, du transistor (GaN_{SENSE}) de détection de courant au GaN, du premier dispositif (116) de protection de la tension et du deuxième dispositif (118) de protection de la tension est un dispositif HEMT, transistor à grande mobilité d'électron, à grille de Schottky, et dans lequel le circuit (114) de détection de courant est mis en œuvre dans du silicium. .
